(19) Europäisches Patentamt
European Patent Office
Office européen des brevets

(11) **EP 2 449 396 B1**

(12) **FASCICULE DE BREVET EUROPEEN**

(45) Date de publication et mention
de la délivrance du brevet:
**16.03.2016 Bulletin 2016/11**

(51) Int Cl.:
*G01R 33/36* *(2006.01)*    *G01R 33/565* *(2006.01)*
*G01R 33/58* *(2006.01)*    *H03F 1/02* *(2006.01)*
*H03F 1/32* *(2006.01)*    *H03F 3/217* *(2006.01)*
*H03G 3/30* *(2006.01)*

(21) Numéro de dépôt: **10730429.7**

(22) Date de dépôt: **30.06.2010**

(86) Numéro de dépôt international:
**PCT/EP2010/059306**

(87) Numéro de publication internationale:
**WO 2011/000882 (06.01.2011 Gazette 2011/01)**

(54) **GENERATEUR D'UN SIGNAL RADIOFREQUENCE MODULE, PROCEDE DE CALIBRATION DU GENERATEUR ET SYSTEME D'IMAGERIE PAR RESONANCE MAGNETIQUE**

GENERATOR FÜR MODULIERTES HOCHFRQUENZSIGNAL, VERFAHREN ZUR KALIBRIERUNG DES GENERATORS UND MAGNETRESONANZBILDGEBUNGSSYSTEM

GENERATOR OF A MODULATED RADIOFREQUENCY SIGNAL, METHOD FOR CALIBRATING THE GENERATOR, AND MAGNETIC RESONANCE IMAGING SYSTEM

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **30.06.2009 FR 0903192**

(43) Date de publication de la demande:
**09.05.2012 Bulletin 2012/19**

(73) Titulaire: **Thales**
**92200 Neuilly Sur Seine (FR)**

(72) Inventeur: **DARGES, Bernard**
**F-95320 Saint Leu La Foret (FR)**

(74) Mandataire: **Collet, Alain**
**Marks & Clerk France**
**Conseils en Propriété Industrielle**
**Immeuble Visium**
**22, Avenue Aristide Briand**
**94117 Arcueil Cedex (FR)**

(56) Documents cités:
**WO-A-00/36800        WO-A-01/91282**
**US-A- 5 901 346        US-A1- 2005 018 787**
**US-A1- 2007 159 243**

# EP 2 449 396 B1

## Description

L'invention concerne un générateur d'un signal modulé de forte puissance, un procédé de calibration du générateur et un système d'imagerie par résonance magnétique. L'invention trouve une utilité particulière dans l'imagerie par résonance magnétique (IRM). Il s'agit d'une technique d'imagerie médicale basée sur la résonance magnétique nucléaire permettant de réaliser des vues en deux ou trois dimensions d'une partie du corps et notamment du cerveau. On applique une onde électromagnétique modulée à haute fréquence, par exemple autour de 127,7MHz à une puissance comprise entre 1 et 30kW voire plus, sur la partie du corps à analyser et on mesure le signal réémis par certains atomes comme l'hydrogène par exemple. Cette technique permet de déterminer la composition chimique et donc la nature des tissus biologiques du volume imagé.

La génération de signaux radiofréquences nécessaires à cette technique d'imagerie nécessite des caractéristiques de linéarités strictes en amplitude et en phase. On doit pouvoir ajuster la puissance de sortie en respectant ces critères de linéarité. Un exemple de critère de linéarité à respecter est de conserver un gain différentiel entre la sortie et l'entrée de: +/- 0,15 dB et une phase différentielle de : +/- 1,25°.

A ce jour les amplificateurs utilisés pour les applications d'imagerie par résonance magnétique sont des amplificateurs linéaires fonctionnant en classe AB. L'emploi de tel amplificateurs nécessite tout de même de mettre en place une correction de linéarité de type « pré distorsion ». Pour qu'une telle correction puisse être utilisée, les amplificateurs de classe AB doivent travailler avec des compressions inférieures à un dB. L'utilisation de ce type de correction se fait dans la bande RF, ce qui peut poser de nombreuses difficultés comme par exemple la stabilité des composants de puissance en température et la variation du gain en fonction de la température. La technologie des composants électroniques mis en oeuvre peut être aussi un facteur bloquant. L'utilisation de la technologie MOS et LDMOS montre une rotation de phase en avance par rapport à la compression contrairement à la technologie bipolaire actuellement abandonnée dans les bandes de fréquence utilisées dans l'imagerie par résonance magnétique. On rappelle que la technologie dite MOS vient de l'anglais « Metal-oxyde semiconductor » pour des transistors dont la grille est isolée de la liaison drain source par une couche d'oxyde. La technologie LDMOS, pour « laterally diffused Metal-oxyde semiconductor », est mise en oeuvre pour des transistors haute fréquence de puissance et est réalisée par mise en oeuvre d'un mode particulier de diffusion des éléments dopants sur le substrat.

L'invention vise à pallier tout ou partie des problèmes cités plus haut et à réduire sensiblement le coût des générateurs actuellement utilisés en proposant d'utiliser des amplificateurs travaillant au delà d'un dB de compression.

Pour créer un signal linéaire utile pour l'application IRM, l'invention prévoit de décomposer l'amplification radiofréquence de puissance P en deux blocs de puissance moitié P/2. La modulation du signal radiofréquence est obtenue par un contrôle de phase de chaque bloc. L'utilisation de deux déphaseurs fixes de même déphasage permet pour le premier, la génération des signaux de commande RF de chaque bloc de puissance, et pour le second, la sommation des signaux de puissance issus de chaque bloc.

• Autrement dit, l'invention a pour objet un générateur d'un signal radiofréquence modulé tel que défini par la revendication 1.

L'invention a également pour objet un procédé de calibration d'un générateur selon l'invention, tel que défini par la revendication 5.

L'invention a aussi pour objet un système d'imagerie par résonance magnétique comprenant un générateur selon l'invention tel que défini par la revendication 6.

Dans la pratique, un tel générateur peut générer des fréquences harmoniques de la fréquence de la porteuse. Il est nécessaire de filtrer ces harmoniques en sortie du générateur. Dans le cadre de l'invention, il est possible de choisir toute valeur non nulle pour la valeur fixe de déphasage. Mais avantageusement, on choisit une valeur de 90°. Ce déphaseur est également appelé déphaseur quadratique. En effet, ce type de déphaseur réduit nettement la production d'harmoniques impairs. On estime que la production d'harmoniques impairs dans un déphaseur à 180° est de l'ordre de -20dB alors que dans un déphaseur quadratique le taux d'harmonique impairs est de l'ordre de -35dB. Le filtrage de sortie est alors facilité. De plus, en mettant en oeuvre des amplificateurs de classe B, couramment appelés amplificateurs à structure dite « push », provenant de l'anglais « pousser », la génération d'harmoniques d'ordre pairs est fortement diminuée. L'association d'un déphaseur quadratique et d'amplificateurs à structure « push » dans le cadre de l'invention permet de réduire la taille des filtres de sortie.

L'invention sera mieux comprise et d'autres avantages apparaîtront à la lecture de la description détaillée d'un mode de réalisation donné à titre d'exemple, description illustrée par le dessin joint dans lequel :

la figure 1 représente schématiquement différents composants d'une première variante d'un générateur conforme à l'invention;
les figures 2 à 6 permettent de mieux comprendre le principe de fonctionnement du générateur de la figure 1 ;

la figure 7 représente une autre variante de réalisation d'un générateur conforme à l'invention ;
la figure 8 permet de mieux comprendre un procédé de calibration d'un générateur conforme à l'invention ;
la figure 9 représente schématiquement un exemple de réalisation du générateur de la figure 1.

Par souci de clarté, les mêmes éléments porteront les mêmes repères dans les différentes figures.

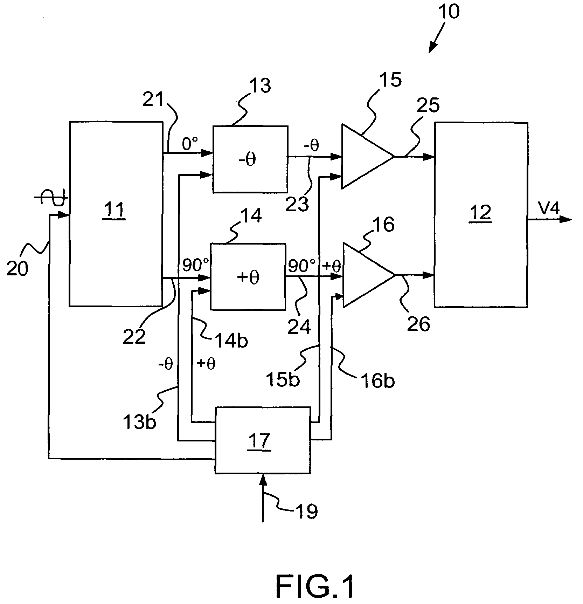

La figure 1 représente un exemple de générateur 10 destiné à être mis en oeuvre dans une application d'imagerie par résonance magnétique. Il est bien entendu que l'invention peut être mise en oeuvre dans tout autre domaine pour lequel les critères de linéarité en amplitude et en phase sont sévères. Le générateur permet de délivrer un signal radiofréquence modulé sur une porteuse de fréquence fixe, par exemple 127,7 MHz telle que couramment utilisée en imagerie par résonance magnétique. D'autres fréquences sont bien entendu possibles sans sortir du cadre de l'invention.

Le générateur 10 comprend deux déphaseurs quadratiques 11 et 12, deux déphaseurs commandés 13 et 14 et deux amplificateurs 15 et 16.

Le premier déphaseur quadratique 11 reçoit sur une entrée 20 un signal sinusoïdal pouvant être modulé en phase ou en fréquence. Ce signal forme une porteuse d'amplitude constante. Le déphaseur quadratique 11 comprend deux sorties 21 et 22 sur lesquelles on retrouve le signal sinusoïdal non déphasé sur la sortie 21 et le signal sinusoïdal déphasé de 90° sur la sortie 22. Les signaux présents sur les deux sorties 21 et 22 ont la même amplitude. Cette amplitude est réduite de 3dB par rapport à l'amplitude de l'entrée 20.

La sortie 21 forme l'entrée du premier déphaseur commandé 13 et la sortie 22 forme l'entrée du second déphaseur commandé 14. Des commandes 13b et 14b des deux déphaseurs respectivement 13 et 14 sont en opposition et sont notées $\theta$ et $-\theta$. Plus précisément, le déphaseur 13 déphase le signal qu'il reçoit d'un angle $\theta$ et le déphaseur 14 déphase le signal qu'il reçoit d'un angle $-\theta$. L'angle $\theta$ est représentatif de l'indice de modulation à appliquer au signal. Le déphaseur 13 comprend une sortie 23 formant l'entrée de l'amplificateur 15 et le déphaseur 14 comprend une sortie 24 formant l'entrée de l'amplificateur 16. Il est possible de mettre en oeuvre des amplificateurs 15 et 16 utilisés au voisinage de leur saturation, comme par exemple des amplificateurs de classe B, D ou E, même si cela génère une compression des signaux supérieure à la linéarité requise en sortie du générateur 10. En pratique, il est possible d'utiliser des amplificateurs dont la compression, en puissance élevée dépasse nettement 1 dB. Chaque amplificateur 15 et 16 comprend une sortie, respectivement 25 et 26 formant deux entrées du déphaseur quadratique 12 qui assure le couplage des signaux issus des amplificateurs 15 et 16 pour délivrer sur une sortie 27 le signal radiofréquence modulé en amplitude en fonction de la phase $\theta$.

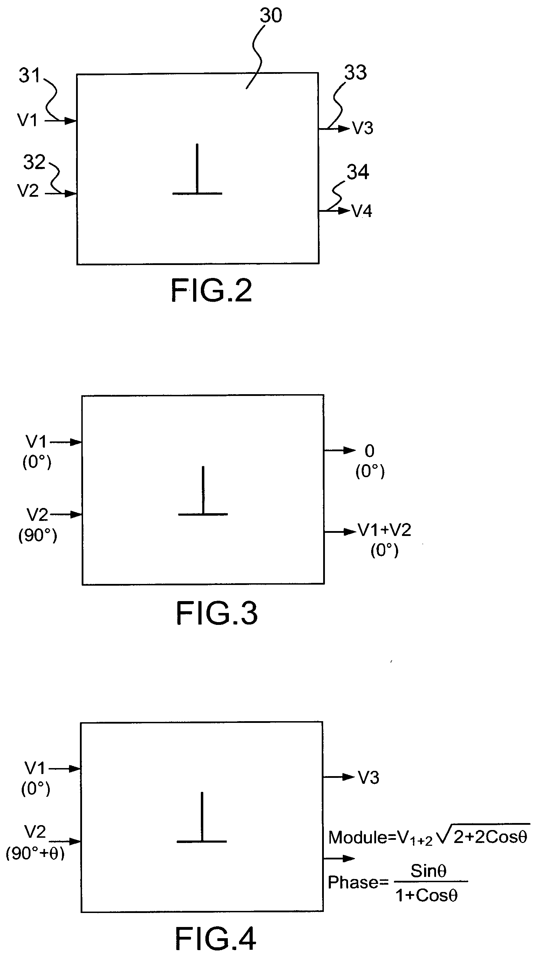

Les figures 2 à 6 permettent de mieux comprendre le principe de fonctionnement du générateur de la figure 1. La figure 2 représente un déphaseur quadratique 30 comprenant deux entrées 31 et 32 ainsi que deux sorties 33 et 34. Des signaux radiofréquence V1 et V2 sont appliqués respectivement aux entrées V1 et V2. Le déphaseur 30 délivre un signal V3 sur la sortie 33 et un signal V4 sur la sortie 34.

De façon générale, les équations (1) et (2) décrivent un signal sinusoïdal d'amplitude $v_1$ et de phase $\Phi1$ pour le signal V1 et d'amplitude $v_2$ et de phase $\Phi2$ pour le signal V2

$$V1 = \frac{v_1}{\sqrt{2}} e^{j\phi_1} \qquad (1)$$

$$V2 = \frac{v_2}{\sqrt{2}} e^{j\phi_2} \qquad (2)$$

En sortie du déphaseur 30, les signaux V3 et V4 sont donnés par les équations (3) et (4)

$$V3 = \frac{v_1}{\sqrt{2}} e^{j(\phi_1 - \frac{\pi}{2})} + \frac{v_2}{\sqrt{2}} e^{j\phi_2} \qquad (3)$$

$$V4 = \frac{v_1}{\sqrt{2}} e^{j(\phi_1)} + \frac{v_2}{\sqrt{2}} e^{j(\phi_2 - \frac{\pi}{2})} \qquad (4)$$

Pour simplifier les écritures des équations (3) et (4), on pose : $\Phi1 = 0$ et $\Phi2 = \Phi1 + \varphi$. On obtient alors :

$$V3 = \frac{v_1}{\sqrt{2}} e^{j(-\frac{\pi}{2})} + \frac{v_2}{\sqrt{2}} e^{j\varphi} \qquad (5)$$

$$V4 = \frac{v_1}{\sqrt{2}} e^{j0} + \frac{v_2}{\sqrt{2}} e^{j(\varphi-\frac{\pi}{2})} \qquad (6)$$

Dans le cas particulier où $\varphi = \frac{\pi}{2}$ et $v_1 = v_2$, on a :

$$V3 = \frac{v_1}{\sqrt{2}} e^{j(-\frac{\pi}{2})} + \frac{v_2}{\sqrt{2}} e^{j(\frac{\pi}{2})} \qquad (7)$$

D'où :

$$V3 = 0 \qquad (8)$$

Et

$$V4 = \frac{v_1}{\sqrt{2}} e^{j0} + \frac{v_2}{\sqrt{2}} e^{j(\frac{\pi}{2}-\frac{\pi}{2})} \qquad (9)$$

$$V4 = (\frac{v_1 + v_2}{\sqrt{2}}) e^{j0} \qquad (10)$$

$$V4 = (V1 + V2) e^{j0} \qquad (11)$$

Ce cas représente le déphaseur 12 lorsque $\theta = 0$ et est représenté sur la figure 3.

Par contre lorsque 6 est différent de 0, on considère $\Phi1 = 0$ et $\phi2 = \phi1 + \frac{\pi}{2} + \theta$. On a alors

$$V3 = \frac{v_1}{\sqrt{2}} e^{j(-\frac{\pi}{2})} + \frac{v_2}{\sqrt{2}} e^{j(\theta+\frac{\pi}{2})} \qquad (12)$$

$$V4 = \frac{v_1}{\sqrt{2}} e^{j0} + \frac{v_2}{\sqrt{2}} e^{j\theta} \qquad (13)$$

En considérant $v_1 = v_2$, on peut exprimer V4 sous forme polaire :

$$V4 = (V1+V2) (Cos(0)+Cos(\theta) +j(Sin(0) + Sin(\theta))) \qquad (14)$$

$$V4 = (V1+V2)(1+\text{Cos}(\theta)+j\text{Sin}(\theta)) \qquad (15)$$

Autrement dit le module de V4 peut s'exprimer sous la forme :

$$(v_1 + v_2)\sqrt{(1+\text{Cos}\theta)^2 + \text{Sin}^2\theta} = (v_1 + v_2)\sqrt{2+2\text{Cos}\theta} \qquad (16)$$

La phase de V4 peut s'exprimer sous la forme :

$$\frac{\text{Sin}\theta}{1+\text{Cos}\theta} \qquad (17)$$

Le module et la phase de V4 sont représentés sur la figure 4. Pour le déphaseur 12, on ne s'intéresse qu'à la sortie 34 ou le signal V4 est présent. Pour pouvoir obtenir une phase constante pour V4, on applique une phase -θ sur l'entrée V1 tout en conservant une phase θ + π/2 sur l'entrée V2. Autrement dit :

$$\phi1 = -\theta$$

$$\phi2 = \phi1 + \frac{\pi}{2} + \theta$$

En considérant toujours que V1 et V2 ont la même amplitude, l'équation (4) devient :

$$V4 = \frac{v_1}{\sqrt{2}}e^{-j\theta} + \frac{v_2}{\sqrt{2}}e^{j(\theta+\frac{\pi}{2}-\frac{\pi}{2})} \qquad (18)$$

$$V4 = \frac{v_1}{\sqrt{2}}e^{-j\theta} + \frac{v_2}{\sqrt{2}}e^{j\theta} \qquad (19)$$

$$V4 = \frac{v_1 + v_2}{2\sqrt{2}}(e^{-j\theta} + e^{j\theta}) \qquad (20)$$

$$V4 = \frac{v_1 + v_2}{2\sqrt{2}}(\text{Cos}\theta - j\text{Sin}\theta + \text{Cos}\theta + j\text{Sin}\theta) \qquad (21)$$

$$V4 = \frac{v_1 + v_2}{\sqrt{2}}\text{Cos}\theta \qquad (22)$$

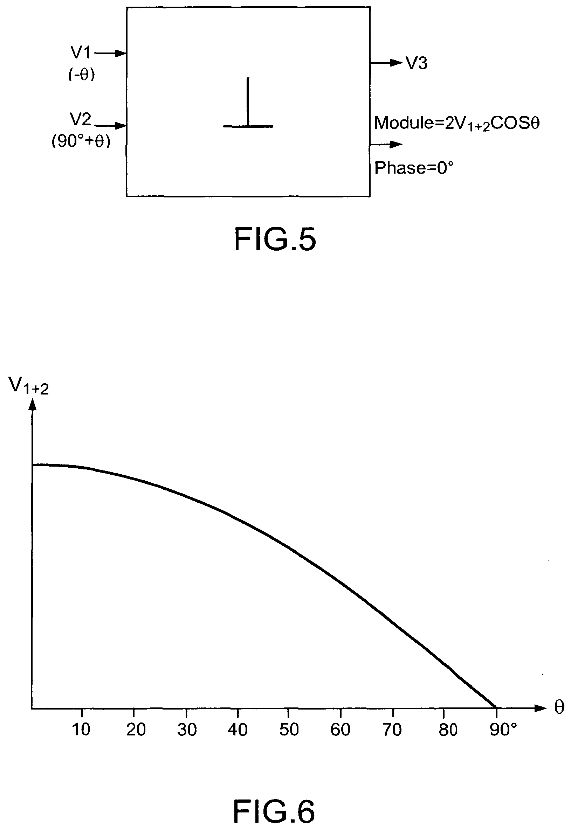

En appelant $V_{1+2}$=V1=V2, on obtient : V4=2$V_{1+2}$Cosθ, ce qui est représenté sur la figure 5.
On constate que la phase du signal 34 est toujours nulle et que son amplitude ne dépend que de l'angle θ. Autrement dit, le signal radiofréquence issu du générateur en modulé en amplitude en fonction d'une commande réalisée par l'angle θ. La figure 6 représente l'évolution de l'amplitude du signal de sortie V4 en fonction de l'angle θ lorsque celui-ci évolue entre 0° et 90°. A partir d'une commande en tension proportionnelle à l'amplitude à obtenir pour la modulation du signal radiofréquence, on pourra utiliser un simple linéarisateur fournissant la fonction réciproque de la fonction de transfert du déphaseur 12. Dans l'exemple considéré où le déphaseur 12 est un déphaseur quadratique, la fonction réciproque est de type « inverse cosinus ».

Le générateur peut également comprendre un calculateur 17 permettant de commander les déphaseurs 13 et 14 avec les angles +θ et v-θ. Le calculateur 17 peut également générer le signal sinusoïdal pur appliqué à l'entrée 20. Le calculateur 17 détermine l'angle θ à partir d'une commande 19 proportionnelle à l'amplitude à obtenir pour la modulation du signal radiofréquence. La commande 19 est par exemple une commande en tension. Avantageusement, le générateur comprend des moyens de blocage des deux amplificateurs 15 et 16. Ce blocage est particulièrement utile dans l'imagerie par résonnance magnétique. En effet, dans cette application, le signal radiofréquence issu du générateur est pulsé. En dehors des périodes où le signal radiofréquence à une amplitude non nulle, il est important d'éviter tout bruit qui serait présent sur les sorties 25 et 26 même lorsque la valeur de θ est de 90°. Ce blocage est par exemple obtenu par des commandes 15b et 16b des amplificateurs 15 et 16, commandes issus du calculateur 17.

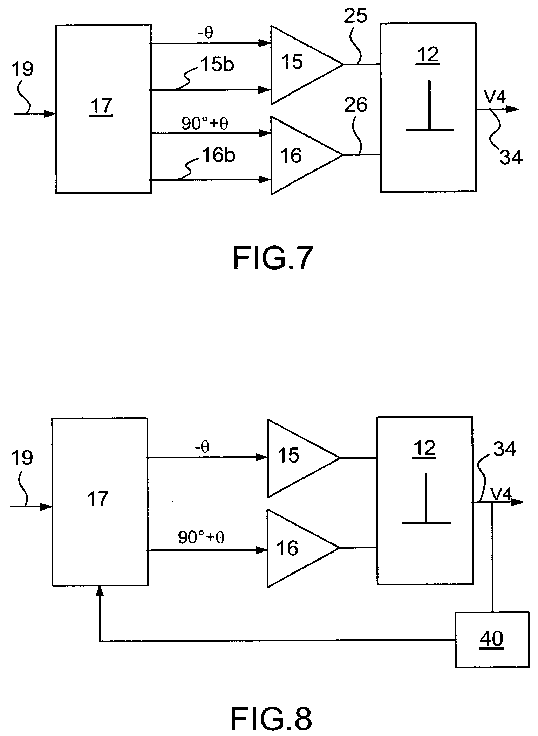

La figure 7 représente une variante de réalisation d'un générateur selon l'invention. Dans cette variante, on se passe du premier déphaseur 11 et des déphaseurs commandés 13 et 14. Le calculateur 17 fournit directement le signal sinusoïdal déphasé de la valeur variable -θ et le signal sinusoïdal déphasé de la valeur variable 90°+θ. Ces signaux sont de faible amplitude et peuvent donc être délivrés par le calculateur 17 à partir de la commande 19 (trame numérique par exemple). Le calculateur 17 génère également les commandes de blocage 15b et 16b.

La figure 8 permet de mieux comprendre un procédé de calibration d'un générateur conforme à l'invention. Pour calibrer le générateur on connecte une sonde de mesure 40 sur la sortie 34 du déphaseur 12. La sonde 40 permet de mesurer l'amplitude et la phase du signal radiofréquence présent sur la sortie 34. La sonde 40 transmet les informations qu'elle mesure au calculateur 17. La figure 8 complète le générateur représenté à la figure 7. Il est bien entendu que ce procédé de calibration s'adapte aussi au générateur de la figure 1.

Lors de la calibration, On applique au calculateur 17 une série de commandes 19 réparties sur une plage d'amplitude où le générateur doit pouvoir fonctionner. La répartition sur la plage se fait en n échelons régulièrement répartis. Pour chaque échelon, on compare la valeur de la commande 19 à la réponse délivrée par la sonde 40. On peut également définir une commande 19 sous forme d'une rampe pour améliorer la linéarité de la calibration.

Dans un premier temps, on détermine pour chaque échelon de commande, un coefficient $C_n$ de correction de l'amplitude de chaque signal sinusoïdal présent sur les sorties 21 et 22 afin d'obtenir une amplitude du signal radiofréquence V4 proportionnelle à la commande 19 avec un taux de linéarité inférieur à une tolérance donnée.

Dans un second temps, on détermine pour chaque échelon de commande, un coefficient φ de correction de la phase de chaque signal sinusoïdal présent sur les sorties 21 et 22 afin d'obtenir une phase nulle du signal radiofréquence V4 avec un taux de linéarité inférieur à une tolérance donnée.

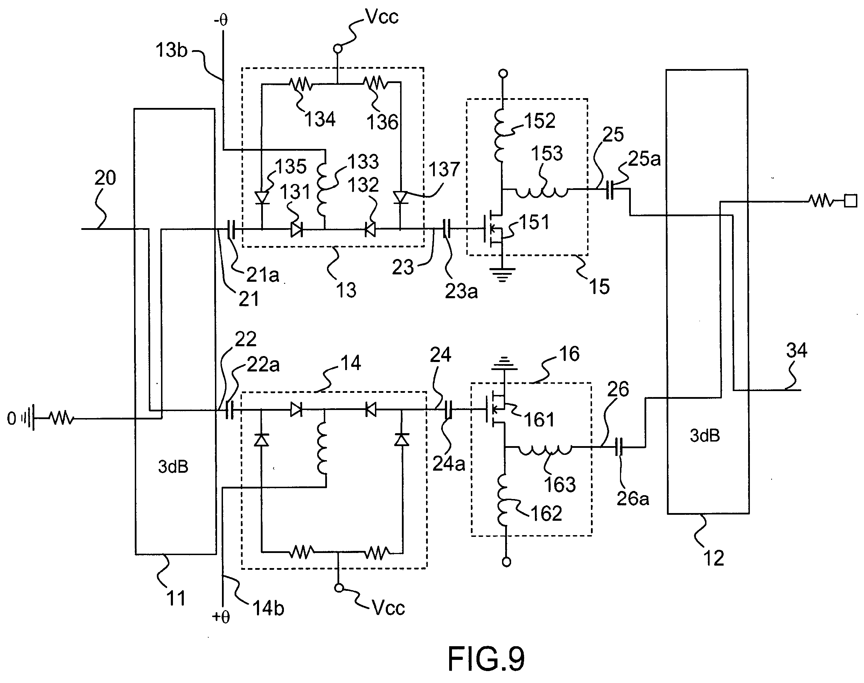

La figure 9 représente schématiquement un exemple de réalisation du générateur 10 de la figure 1.

On y retrouve les deux déphaseurs quadratiques 11 et 12 que l'on peut réaliser au moyen de lignes de transmission de longueur égale au quart de la longueur d'onde du signal sinusoïdal présent sur l'entrée 20. On peut réduire les dimensions physiques des déphaseurs quadratiques 11 et 12 en mettant en oeuvre un substrat à fort permittivité comme par exemple un substrat céramique ou encore en repliant les lignes de transmission.

Sur la figure 9, les déphaseurs commandés 13 et 14 peuvent par exemple utiliser des diodes comportant une zone non dopée, dite zone intrinsèque, intercalée entre des zones dopées, l'une positive et l'autre négative. Par la suite ce type de diode sera appelé diode PIN en référence à son appellation dans la littérature anglo-saxonne : « Positive Intrinsic Negative Diode ». Les diodes PIN sont utilisées pour leur variation de capacité en fonction de la polarité qui lui est appliquée. Plus précisément, le déphaseur 13 comprend deux diodes 131 et 132 montées tête bêche en série entre l'entrée 22 et la sortie 23. On peut faire varier la capacité des deux diodes 131 et 132 en appliquant en leur cathode commune la commande 13b sous forme d'une polarisation. Une self d'arrêt 133 peut être placée entre la commande 13b et les cathodes de diodes 131 et 132 afin d'éviter que le signal radiofréquence ne vienne perturber le calculateur 17. Le déphaseur 13 est par ailleurs alimenté par une tension continue notée Vcc. Cette tension est reliée d'une part à l'entrée 21 par l'intermédiaire d'une résistance 134 et d'une diode 135 reliées en série. La cathode de la diode 135 est raccordée à l'anode de la diode 131. La tension Vcc est d'autre part reliée à la sortie 23 par l'intermédiaire d'une résistance 136 et d'une diode 137 reliées en série. La cathode de la diode 137 est raccordée à l'anode de la diode 132.

La capacité des diodes 135 et 137 ne varie pas sous l'effet de la commande 13b. Le déphasage est assuré par la combinaison de sous ensembles de type RC, d'une part la résistance 134 associée aux diodes 131 et 135 et d'autre part la résistance 136 associée aux diodes 132 et 137.

Le déphaseur 14 est semblable au déphaseur 13. Les commandes 13b et 14b assurent par exemple avec une même tension de commande un déphasage moyen de +45° pour le déphaseur 14 et +45° pour le déphaseur 13. Pour assurer la création du signal radiofréquence ou autres types souhaité en sortie 34 du déphaseur 12, on fait varier les tensions de commandes 13b et 14b en sens opposé autour d'une tension moyenne Vcc/2 (tension assurant le déphasage relatif entre chaque voie). A titre d'exemple, pour une tension Vcc/2 appliquée sur les commandes 13b et 14b, la tension de sortie du déphaseur 12 sera maximale. Pour une tension (Vcc/2 - Δu) sur 13b et (Vcc/2 + Δu) sur 14b, la tension en sortie 34 sera réduite en amplitude. L'écart de tension entre les deux voies 2Δu correspond à l'écart relatif de phase de 2θ.

Les amplificateurs 15 et 16 sont dans l'exemple représenté sur la figure 9 des amplificateurs de classe E. Ils comprennent chacun un transistor à grille isolée, 151 pour l'amplificateur 15 et 161 pour l'amplificateur 16, attaqué à sa grille par le signal présent à la sortie de chaque déphaseur commandé 13 et 14. Les émetteurs ou sources des transistors 151 et 161 sont reliés à une masse électrique du générateur 10 et le collecteurs ou drains des transistors 151 et 161 sont reliés d'une part à la tension Vcc par l'intermédiaire d'une self d'arrêt, respectivement 152 et 162 et d'autre par aux sorties respectivement 25 et 26 par l'intermédiaire d'une self d'accord, respectivement 153 et 163.

Les liaisons entre les différents éléments déphaseurs 11 à 14 et amplificateurs 15 et 16 peuvent comprendre chacune un condensateur de liaison respectivement 21 a pour la liaison 21, 22a pour la liaison 22, 23a pour la liaison 23, 24a pour la liaison 24, 25a pour la liaison 25 et 26a pour la liaison 26.

## Revendications

1. Générateur d'un signal radiofréquence modulé en amplitude, **caractérisé en ce qu'**il comprend :

   • des moyens (11, 13, 14, 17) pour générer un signal sinusoïdal (23) déphasé d'une première valeur variable (-θ) par rapport à une référence de phase et un signal sinusoïdal (24) déphasé d'une valeur fixe donnée non nulle additionnée à une seconde valeur variable (+θ) par rapport à la référence de phase, la seconde valeur variable étant opposée de la première valeur variable par rapport à la référence de phase, les valeurs variables (-θ, θ) étant représentatives de la modulation du signal radiofréquence, les deux signaux sinusoïdaux étant d'amplitude constante,
   • un premier amplificateur (15) amplifiant un premier des deux signaux sinusoïdaux dans un régime saturé ou au voisinage de sa saturation,
   • un second amplificateur (16) amplifiant un second des deux signaux sinusoïdaux dans un régime saturé ou au voisinage de sa saturation,
   • un déphaseur fixe (12) de valeur égale à l'opposée de la valeur fixe donnée non nulle des moyens pour générer les deux signaux sinusoïdaux, le déphaseur fixe (12) couplant les signaux issus des deux amplificateurs (15, 16) pour délivrer le signal radiofréquence modulé en amplitude.

2. Générateur selon la revendication 1, **caractérisé en ce que** les moyens pour générer les deux signaux sinusoïdaux comprennent :

   • un premier déphaseur fixe (11) permettant de fournir à partir d'une porteuse radiofréquence à amplitude constante un signal sinusoïdal non déphasé et ce même signal déphasé de la valeur fixe donnée,
   • un premier déphaseur commandé (13) déphasant le signal sinusoïdal non déphasé de la première valeur variable (-θ),
   • un second déphaseur commandé (14) déphasant le signal sinusoïdal déphasé de la seconde valeur variable (θ).
   • les deux amplificateurs (15, 16).

3. Générateur selon l'une des revendications précédentes, **caractérisé en ce que** la valeur de déphasage fixe donnée est de 90°.

4. Générateur selon l'une des revendications précédentes, **caractérisé en ce qu'**il comprend des commandes (15a, 16a) des deux amplificateurs (15, 16) permettant de bloquer les deux amplificateurs (15, 16).

5. Procédé de calibration d'un générateur selon l'une des revendications 1 à 4, **caractérisé en ce qu'**il consiste à appliquer une série de commandes de modulation (19) réparties en n échelons sur une plage d'amplitude, et de déterminer pour chaque échelon de commande (19) des coefficients ($C_n$, φ) de correction de l'amplitude et de la phase de chacun des signaux sinusoïdaux (23, 24) afin d'obtenir un taux de linéarité d'amplitude et de phase du signal radiofréquence modulé en fonction de la commande de modulation (19), le taux de linéarité étant compris à l'intérieur d'un intervalle de tolérance donné.

6. Système d'imagerie par résonance magnétique comprenant un générateur selon l'une des revendications 1 à 4.

## Patentansprüche

1. Generator eines amplitudenmodulierten Funkfrequenzsignals, **dadurch gekennzeichnet, dass** er Folgendes umfasst:

• Mittel (11, 13, 14, 17) zum Erzeugen eines sinusförmigen Signals (23), das um einen ersten variablen Wert (-θ) relativ zu einer Phasenreferenz phasenverschoben ist, und eines sinusförmigen Signals (24), das um einen gegebenen festen Wert von ungleich null addiert zu einem zweiten variablen Wert (+θ) relativ zu der Phasenreferenz phasenverschoben ist, wobei der zweite variable Wert entgegengesetzt zu dem ersten variablen Wert relativ zu der Phasenreferenz ist und wobei die variablen Werte (-θ,θ) die Modulation des Funkfrequenzsignals repräsentieren, wobei die zwei sinusförmigen Signale eine konstante Amplitude haben;
• einen ersten Verstärker (15), der ein erstes der zwei sinusförmigen Signale in einem gesättigten Modus oder in der Nähe des Sättigungspunkts verstärkt;
• einen zweiten Verstärker (16), der ein zweites der zwei sinusförmigen Signale in einem gesättigten Modus oder in der Nähe des Sättigungspunkts verstärkt;
• einen festen Phasenschieber (12) mit einem gleichen Wert entgegengesetzt dem gegebenen festen Wert von ungleich null der Mittel zum Erzeugen der zwei sinusförmigen Signale, wobei der feste Phasenschieber (12) die von den zwei Verstärkern (15, 16) kommenden Signale koppelt, um das amplitudenmodulierte Funkfrequenzsignal zu liefern.

2. Generator nach Anspruch 1, **dadurch gekennzeichnet, dass** die Mittel zum Erzeugen der zwei sinusförmigen Signale Folgendes umfassen:

• einen ersten festen Phasenschieber (11) zum Liefern, auf der Basis eines Funkfrequenzträgers mit konstanter Amplitude, eines nicht phasenverschobenen sinusförmigen Signals und desselben um den gegebenen festen Wert phasenverschobenen Signals;
• einen ersten gesteuerten Phasenschieber (13), der das nicht durch den ersten variablen Wert (-θ) phasenverschobene sinusförmige Signal phasenverschiebt;
• einen zweiten gesteuerten Phasenschieber (14), der das durch den zweiten variablen Wert (θ) phasenverschobene sinusförmige Signal phasenverschiebt;
• die zwei Verstärker (15, 16).

3. Generator nach einem der vorherigen Ansprüche, **dadurch gekennzeichnet, dass** der gegebene feste Phasenverschiebungswert 90° beträgt.

4. Generator nach einem der vorherigen Ansprüche, **dadurch gekennzeichnet, dass** er Steuerungen (15a, 16a) für die zwei Verstärker (15, 16) umfasst, die das Sparren der zwei Verstärker (15, 16) zulassen.

5. Verfahren zum Kalibrieren eines Generators nach einem der Ansprüche 1 bis 4, **dadurch gekennzeichnet, dass** es das Anwenden einer Serie von Modulationsbefehlen (19), verteilt auf n Schritte über einen Amplitudenbereich, und das Ermitteln, für jeden Steuerschritt (19), der Koeffizienten ($C_n$, φ) zum Korrigieren der Amplitude und der Phase von jedem der sinusförmigen Signale (23, 24) beinhaltet, um einen Grad an Amplituden- und Phasenlinearität des modulierten Funkfrequenzsignals in Abhängigkeit von der Modulationssteuerung (19) zu erhalten, wobei der Linearitätsgrad innerhalb eines gegebenen Toleranzintervalls liegt.

6. Magnetresonanzabbildungssystem, das einen Generator nach einem der Ansprüche 1 bis 4 umfasst.

**Claims**

1. A generator of an amplitude-modulated radiofrequency signal, **characterised in that** it comprises:

• means (11, 13, 14, 17) for generating a sinusoidal signal (23) phase-shifted by a first variable value (-θ) relative to a phase reference and a sinusoidal signal (24) phase-shifted by a given fixed non-zero value added to a second variable value (+θ) relative to said phase reference, said second variable value being in opposition to said first variable value relative to said phase reference, said variable values (-θ,θ) representing the modulation of said radiofrequency signal, said two sinusoidal signals having constant amplitude;
• a first amplifier (15) amplifying a first one of said two sinusoidal signals in a saturation mode or in the vicinity of its saturation point;
• a second amplifier (16) amplifying a second one of said two sinusoidal signals in a saturation mode or in the vicinity of its saturation point;
• a fixed phase-shifter (12) of equal value to the opposite of the given fixed non-zero value of said means for generating said two sinusoidal signals, said fixed phase-shifter (12) coupling the signals coming from said two amplifiers (15, 16) so as to deliver the amplitude-modulated radiofrequency signal.

2. The generator according to claim 1, **characterised in that** said means for generating said two sinusoidal signals comprise:

• a first fixed phase-shifter (11) allowing, from a constant amplitude radiofrequency carrier, a non-phase-shifted sinusoidal signal and said signal phase-shifted by said given fixed value to be supplied;
• a first controlled phase-shifter (13) phase-shifting said sinusoidal signal not phase-shifted by said first variable value ($-\theta$);
• a second controlled phase-shifter (14) phase-shifting said sinusoidal signal phase-shifted by said second variable value ($\theta$);
• said two amplifiers (15, 16).

3. The generator according to any one of the preceding claims, **characterised in that** said given fixed phase-shifting value is 90°.

4. The generator according to any one of the preceding claims, **characterised in that** it comprises controls (15a, 16a) for said two amplifiers (15, 16) allowing said two amplifiers (15, 16) to be blocked.

5. A method for calibrating a generator according to any one of claims 1 to 4, **characterised in that** it comprises applying a series of modulation commands (19) divided into n steps over an amplitude range and determining, for each control step (19), coefficients ($C_n$, $\varphi$) for correcting the amplitude and the phase of each of said sinusoidal signals (23, 24) so as to obtain a degree of amplitude and of phase linearity of said modulated radiofrequency signal as a function of said modulation control (19), said degree of linearity being within a given tolerance interval.

6. A magnetic resonance imaging system comprising a generator according to any one of claims 1 to 4.

FIG.1

FIG.2

FIG.3

FIG.4

FIG.5

FIG.6

**FIG.7**

**FIG.8**

FIG.9

EP 2 449 396 B1